Europäisches Patentamt

European Patent Office

Office européen des brevets

(19)

(11) **EP 1 021 599 B1**

(12) **FASCICULE DE BREVET EUROPEEN**

(45) Date de publication et mention
de la délivrance du brevet:
**27.03.2002 Bulletin 2002/13**

(51) Int Cl.$^7$: **C30B 15/34**, C30B 15/00

(21) Numéro de dépôt: **98949032.1**

(22) Date de dépôt: **09.10.1998**

(86) Numéro de dépôt international:
**PCT/FR98/02171**

(87) Numéro de publication internationale:
**WO 99/19545 (22.04.1999 Gazette 1999/16)**

(54) **FILIERE POUR LE TIRAGE DE CRISTAUX A PARTIR D'UN BAIN FONDU**

DÜSE FÜR KRISTALLZIEHUNG AUS EINER SCHMELZE

DIE FOR SHAPED CRYSTAL GROWTH FROM A MOLTEN BATH

(84) Etats contractants désignés:
**DE GB IT**

(30) Priorité: **10.10.1997 FR 9712680**

(43) Date de publication de la demande:
**26.07.2000 Bulletin 2000/30**

(73) Titulaire: **COMMISSARIAT A L'ENERGIE
ATOMIQUE
75015 Paris (FR)**

(72) Inventeurs:
• **THEODORE, Fred**
**F-38000 Grenoble (FR)**
• **DELEPINE, Jean**
**F-38610 Gières (FR)**
• **NABOT, Jean-Philippe**
**F-38120 Saint-Egrève (FR)**
• **KURLOV, Vladimir**
**Moskovskaya obl., 142432 (RU)**

(74) Mandataire: **Des Termes, Monique et al
Société Brevatome
3, rue du Docteur Lancereaux
75008 Paris (FR)**

(56) Documents cités:
**EP-A- 0 653 504        US-A- 4 430 305**

• **BORODIN V A ET AL: "LOCAL SHAPING
TECHNIQUE AND NEW GROWTH APPARATUS
FOR COMPLEX SAPPHIRE PRODUCTS"
JOURNAL OF CRYSTAL GROWTH, vol. 104, no.
1, 1 juillet 1990, pages 69-76, XP000164471**
• **PATENT ABSTRACTS OF JAPAN vol. 009, no.
254 (C-308), 11 octobre 1985 & JP 60 108398 A
(TOSHIBA KK), 13 juin 1985**

## Description

## Domaine technique

La présente invention a pour objet une filière pour le tirage de cristaux à partir d'un bain fondu, utilisable en particulier dans les procédés de solidification dits de croissance capillaire.

Ces procédés consistent à fabriquer une pièce en matériau polycristallin ou monocristallin par tirage au travers d'une filière à partir d'un bain du matériau fondu et cristallisation du matériau fondu sortant de la filière sur un germe.

L'invention s'applique notamment à l'élaboration de pièces de forme complexe réalisées en divers matériaux, par exemple en oxydes, en silicium, en aluminium ou en d'autres métaux, sous forme mono- ou polycristalline.

## Etat de la technique antérieure

Des procédés de fabrication de pièces en matériau monocristallin, ou polycristallin par croissance à partir d'un bain fondu sont connus depuis longtemps et ont été décrits par exemple dans le document 1 : H.E. La Belle, Jr., Journal of Crystal Growth, 50, 1980, pages 8 à 17, et dans le document 2 : Y.A. Tatarchenko, Shaped Crystal Growth, Kluwer Academic Publishers, 1993, 6, pages 1 à 18.

Dans le document 1, on décrit plus spécialement le procédé de tirage dit EFG (Edge-defined, Film-fed, Growth), dans lequel on utilise pour le tirage une filière comportant un canal capillaire réalisé en un matériau mouillé par le bain fondu.

Dans le document 2, on décrit divers procédés de croissance cristalline et en particulier des procédés de préformage utilisant des filières de forme appropriée.

Le document 3 : EP-A-653 504 décrit un procédé de fabrication de pièces en matériau polycristallin ou monocristallin par croissance cristalline à partir d'un bain liquide du matériau fondu. Dans ce procédé, on utilise une filière à travers laquelle on tire le matériau fondu que l'on cristallise sur un germe, et l'on soumet la filière et/ou le germe à au moins un mouvement de translation dans un plan perpendiculaire à la direction de tirage. Ceci permet en particulier de réaliser des pièces de forme complexe.

Le document 4 : US-A-4 430 305 décrit une filière à tubes capillaires adaptée au tirage de pièces en silicium ayant la forme d'une plaque. Cette filière présente une forme particulière pour favoriser l'apparition de l'impureté SiC sur un seul côté de la plaque produite.

Ainsi, les développements récents des procédés de préformage mettent tous en oeuvre des dispositifs de tirage qui permettent l'élaboration de formes particulières grâce au tirage vertical, combiné aux mouvements relatifs horizontaux du germe sur lequel on solidifie, par rapport à la filière qui alimente en matériau fondu.

Certaines installations dérivent d'un four Czochralski, où germe et creuset sont animés d'un mouvement de rotation ω autour d'un axe vertical Z, et d'une translation le long de ce même axe.

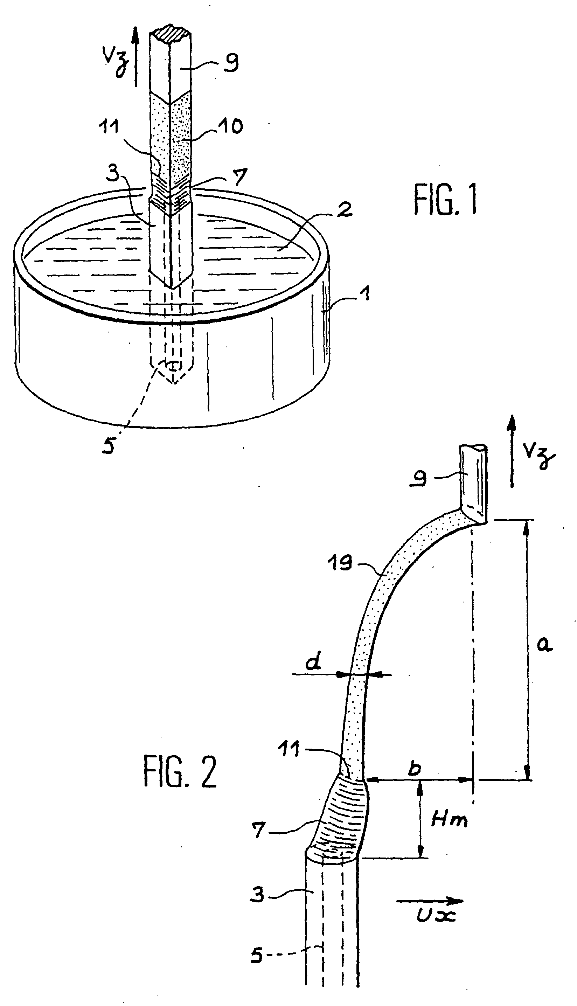

La figure 1 annexée représente le cas simple du préformage classique d'un barreau où seule la translation verticale du germe est utilisée.

Dans un tel procédé, l'alimentation se fait en général à partir d'un creuset 1 contenant le liquide 2 à solidifier, par l'intermédiaire d'une filière 3 qui comporte au moins un perçage interne, soit un canal capillaire 5, dans lequel le liquide provenant du creuset peut circuler soit par remontée capillaire, dans le cas où le liquide mouille le matériau de la filière, soit sous l'effet d'une différence de pression entre la surface du liquide 2 dans le creuset et la sortie de la filière. A la sortie de la filière 3, on obtient un ménisque liquide 7 et la solidification du liquide est amorcée sur un germe monocristallin 9 et se poursuit par tirage de ce germe et du solide formé 10 vers le haut dans le sens de la flèche, à la vitesse Vz. La forme précise du solide obtenu dépend de la distance entre l'interface 11 de solidification et la sortie de la filière 3 mais reste toujours proche de cette dernière. Le positionnement de cet interface peut être réglé en contrôlant l'apport de calories au creuset 1.

Le préformage local fait intervenir un mouvement supplémentaire : la rotation du germe sur lui-même.

Dans le document 3, le procédé décrit permet de tirer par préformage classique (i.e. sans rotation du germe) des formes courbes, ou des pièces de révolution par préformage local (i.e. avec rotation du germe).

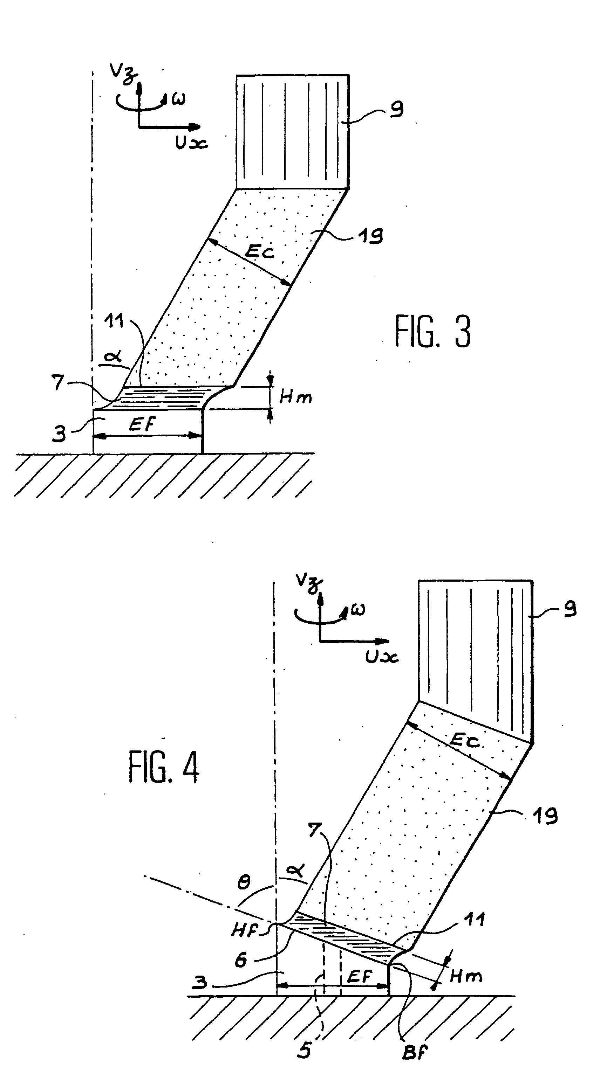

La figure 2 annexée représente l'obtention d'une baguette courbe 19 de section circulaire, en utilisant les mouvements combinés de tirage vertical et de translation dans le sens horizontal du germe 9 et de la pièce en cours de solidification.

Sur cette figure, on voit la filière 3 percée d'un canal central 5 par lequel pénètre le liquide pour former à la sortie de la filière un ménisque 7 avec une interface solide-liquide 11 de la pièce en cours de solidification 19. Dans ce cas, on déplace le germe 9 dans le sens vertical à la vitesse Vz en faisant décrire à la filière 3 un mouvement de translation horizontale à une vitesse Ux appropriée. Le diamètre de la filière est adapté de manière à obtenir le diamètre voulu $\underline{d}$ de la baguette courbe 19, lequel dépend également de la position de l'interface 11 au-dessus de la filière 3. Pour obtenir une baguette ayant la forme d'une branche d'ellipse de demi-axes $\underline{a}$ et $\underline{b}$, le mouvement de translation horizontale de la filière est effectué entre une première position dans laquelle le germe et la filière sont alignés et une deuxième position dans laquelle le germe est à la distance $\underline{b}$ de la filière, et on règle la vitesse de tirage vertical Vz et la fonction de translation horizontale Ux de la filière en fonction du temps t, de façon à avoir :

$$V_z = (\pi a/2\tau) \sin (\pi t/2\tau) \text{ et } U_x = (\pi b/2\tau) \cos (\pi t/2\tau)$$

avec $\tau$ représentant la durée de tirage et $\underline{a}$ et $\underline{b}$ représentant respectivement les demi-axes de l'ellipse.

Dans les procédés décrits ci-dessus, on utilise les mêmes filières que celles développées pour le préformage classique, c'est-à-dire des filières dont la face supérieure est horizontale, soit perpendiculaire à l'axe du perçage et à la direction de tirage. Avec de telles filières, le contrôle de la forme donnée au matériau préformé se fait uniquement au niveau du ménisque fluide 7. Sa géométrie dépend de la constante capillaire du matériau fondu et des conditions aux limites de contact sur la filière. La forme du ménisque et son contact sur la filière sont donc les seuls paramètres qui déterminent localement la forme du cristal.

Quelle que soit la hauteur Hm du ménisque, liée à la nature du matériau et au profil thermique dans le four, l'équilibre de la goutte fluide sur la filière horizontale conduit toujours pour les grands angles de tirage à une épaisseur de cristal trop faible pour que le procédé de démarrage horizontal soit viable.

On a aussi constaté que l'utilisation de filières dont la face supérieure est horizontale est également limitée par le problème d'accrochage du ménisque sur toute la section de cette face. Le contrôle de forme devient là encore déficient, et rend le procédé de démarrage horizontal non viable.

Sur la figure 3, qui représente schématiquement un procédé de préformage analogue à celui de la figure 2, utilisant les mêmes références, on voit que l'épaisseur Ec du cristal 19 tiré avec la filière 3 à face supérieure horizontale dépend de la dimension caractéristique Ef de la filière 3, de la hauteur du ménisque Hm et de l'angle de tirage $\alpha$. Cet angle de tirage est uniquement fonction des vitesses imposées pour la croissance. Par exemple, sur la figure 2, où l'on nomme Ux la vitesse de translation horizontale et Vz la vitesse de tirage vertical, l'angle de tirage est donné par :

$$\text{tg}\,\alpha = \frac{U_x}{V_z} \qquad (R1)$$

Lorsque la hauteur du ménisque Hm est négligeable devant Ef (c'est le cas par exemple pour le saphir), l'épaisseur Ec du cristal est donnée par :

$$E_c = E_f \cdot \cos \alpha \qquad (R2)$$

La relation (R2) révèle un handicap majeur dans le préformage utilisant les filières classiques : la limitation géométrique de l'angle de tirage pour garder au cristal une épaisseur non nulle. A l'évidence, un angle de tirage de 90° sur la verticale est impossible avec une filière classique à sommet horizontal.

Ainsi, ces filières classiques ne conviennent pas pour de grands angles de tirage et, en particulier, pour réaliser un démarrage horizontal de la croissance cristalline.

## Exposé de l'invention

La présente invention a précisément pour objet une filière pour le tirage de monocristaux ou de polycristaux à partir d'un bain fondu, qui pallie cet inconvénient.

Dans ce but, l'invention propose une filière pour le tirage de monocristaux ou de polycristaux à partir d'un bain fondu, comportant un corps percé d'au moins un canal capillaire longitudinal disposé entre une face inférieure du corps destinée à être immergée dans le bain fondu et une face supérieure du corps destinée à supporter le liquide provenant du bain fondu par le (les) canaux capillaires, dans laquelle ladite face supérieure comprend au moins une surface plane sur laquelle débouche le (les) canaux capillaire(s), ladite surface plane formant un angle $\theta$ inférieur à 90°, par exemple de 45°, avec l'axe longitudinal du (des) canaux capillaires.

Cette filière comporte ainsi une surface supérieure plane supportant le liquide en cours de solidification, qui est inclinée par rapport à l'horizontale, ce qui permet de réaliser dans des conditions satisfaisantes la croissance horizontale nécessaire pour l'élaboration de certaines formes, comme par exemple un ellipsoïde ou un pàraboloïde de révolution, des pièces coudées à 90° etc.

Selon l'invention, cette surface plane sur laquelle débouche le canal capillaire définit donc un seul et unique plan dans l'espace.

La filière de l'invention peut comporter un seul canal capillaire, par exemple de section transversale circulaire, carrée, rectangulaire ou en forme de couronne circulaire. Elle peut aussi comporter plusieurs canaux capillaires de section circulaire ou encore plusieurs canaux capillaires de section circulaire débouchant en dessous de la face supérieure de la filière dans un seul canal capillaire de section transversale rectangulaire, comme il est décrit d'ans le document 4 : US-A-4 430 305.

Les bords de l'ouverture du canal capillaire sur la surface plane de la face supérieure de la filière peuvent faire un angle de 90° avec cette surface plane, ou encore former un angle inférieur à 90°, par exemple de 45°, avec cette surface.

Selon un mode de réalisation préféré, la filière de l'invention comprend un seul canal capillaire et une face supérieure dont une partie seulement forme la surface plane faisant un angle $\theta$ inférieur à 90° avec l'axe longitudinal du canal capillaire, le canal capillaire débouchant sur cette surface plane par un tronçon incliné par rapport à l'axe longitudinal du canal.

Ce tronçon a généralement une section transversale plus faible que celle du reste du canal capillaire.

Par ailleurs, on préfère que les bords de l'ouverture par laquelle le tronçon débouche sur la surface plane de la face supérieure de la filière forment un angle inférieur à 90° avec cette surface plane.

A titre d'exemple, cet angle peut être de 45° comme l'angle θ.

Les filières de l'invention peuvent être réalisées en divers matériaux à condition que celui-ci soit chimiquement inerte avec le bain fondu et qu'il soit, de préférence, mouillé par ce dernier. On peut les réaliser en particulier en molybdène.

D'autres caractéristiques et avantages de l'invention apparaîtront mieux à la lecture de la description qui suit d'exemples de réalisation donnés bien entendu à titre illustratif et non limitatif, en référence aux dessins annexés.

**Brève description des dessins**

La figure 1 déjà décrite illustre schématiquement le procédé classique de tirage de l'art antérieur dans lequel seul le germe est animé d'un mouvement de translation vertical.

Les figures 2 et 3 déjà décrites illustrent le procédé classique de préformage de l'art antérieur utilisant deux mouvements de translation.

La figure 4 est une représentation schématique d'un procédé de préformage d'une forme courbe conforme au procédé décrit dans EP-A-653 504, mais utilisant une filière conforme à l'invention.

La figure 5 est une vue en perspective d'une filière conforme à l'invention.

Les figures 6A, 6B, 6C illustrent la réalisation d'une calotte hémisphérique au moyen d'une filière conforme à l'invention.

Les figures 7A, 7B, 7C illustrent la réalisation d'une pièce coudée avec une filière conforme à l'invention.

**Exposé détaillé des modes de réalisation**

En se reportant à la figure 4 sur laquelle on a repris les mêmes numéros que sur les figures 1 à 3 pour référencer la filière 3, le germe 9, le cristal 19, le ménisque fluide 7 et l'interface de solidification 11, on voit qu'en utilisant une filière conforme à l'invention, la face supérieure 6 de cette filière fait un angle θ inférieur à 90° avec l'axe longitudinal du canal capillaire 5, soit avec la verticale.

Dans ces conditions, la dimension caractéristique Ec du cristal élabore est toujours liée à celle de la filière et à l'angle de tirage α. La hauteur Hm du ménisque intervient elle aussi, mais la forme du cristal obéit à la relation simple (R3) qui suit, quel que soit le matériau, lorsque Hm est négligeable devant la dimension Ef de la filière.

$$Ec = Ef\left(1 - \frac{\sin \alpha}{tg\,\theta}\right) \quad (R3).$$

De simples considérations géométriques montrent que la gamme d'angles de tirage α théoriquement possibles passe de $[-\pi/2 ; \pi/2]$ avec la filière horizontale (relation R1) à $[-\theta ; \pi/2]$ avec la filière de l'invention (relation R3).

L'étendue des α possibles est diminuée (π à $\pi/2+\theta$) mais on obtient par l'inclinaison θ une translation de l'intervalle expérimentalement réalisable, particulièrement intéressante lorsque le procédé ne compte pour la vitesse horizontale Ux que des valeurs de signe constant. Cela est couramment réalisé pour l'élaboration des pièces de révolution à section variable. L'inversion de Ux reste possible dans la limite où l'angle de tirage α reste supérieure à -θ. Dans ce dernier cas, on peut utiliser une filière comportant sur sa face supérieur deux surfaces planes faisant respectivement un angle +θ et -θ avec l'axe du canal capillaire. Dans ce cas, chaque surface plane présente une ouverture sur laquelle débouche le canal capillaire. On peut aussi utiliser deux canaux capillaires en relation chacun avec une seule ouverture. Une telle filière permet une gamme d'angle de tirage tout à fait symétrique.

Avec la filière de l'invention, il existe une différence de température dans la zone de cristallisation. En effet, la différence de hauteur entre les points haut Hf et bas Bf de la surface plane 6 de la filière entraîne un écart de température entre ces mêmes points dans la zone chaude axisymétrique du four. Bf se retrouve à plus haute température que Hf. Contre toute attente, ce gradient thermique améliore la croissance en ce qu'il facilite l'accrochage du ménisque 7 en Hf, et garantit un excellent contrôle de la forme en ce point. Par ailleurs, diverses solutions telles que l'écrantage thermique et une géométrie du support de la filière, permettent de résoudre le problème de surchauffe en Bf, et d'obtenir en ce point une maîtrise du procédé tout aussi performante qu'en Hf.

Ainsi, la filière de l'invention résout définitivement le problème de la croissance horizontale nécessaire pour l'élaboration de certaines formes telles qu'ellipsoïde ou paraboloïde de révolution, et pièces coudées à 90°.

Par ailleurs, elle peut être utilisée dans tous les procédés de préformage classique et local tels que ceux décrits dans le document 3 : EP-A-653 504, donnant ainsi la possibilité de changer de manière contrôlée et continue la forme de la pièce tirée.

Enfin, l'utilisation de cette filière permet, quel que soit le matériau soumis au tirage, un véritable pilotage du procédé basé sur les spécifications géométriques de la pièce à réaliser.

Une régulation thermique fine permet d'être toujours dans l'hypothèse où la hauteur du ménisque est très faible par rapport au diamètre de la filière Ef et donc de vérifier les relations R1 et R3 données ci-dessus sur l'angle de tirage α et l'épaisseur Ec du cristal tiré.

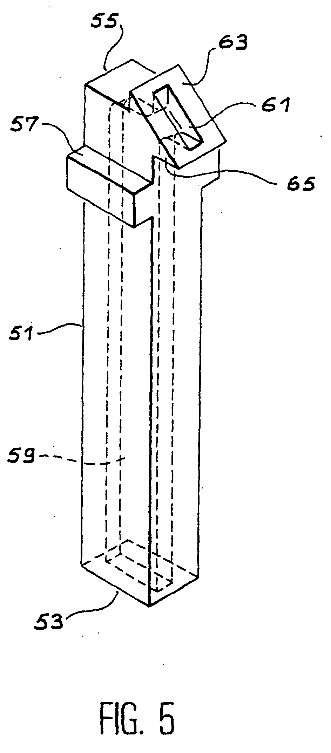

Sur la figure 5, on a représenté en perspective une filière conforme au mode préféré de réalisation de l'invention. Cette filière comprend un corps 51, une face inférieure 53, une face supérieure 55 et un' épaulement 57 servant de support dans l'installation de tirage. Cette filière est percée d'un canal capillaire 59 de section rectangulaire, qui débouche, d'une part, sur la face inférieure 53 et d'autre part sur la face supérieure 55 par l'ouverture 61, également de section rectangulaire.

Cette face supérieure est conformée de façon à présenter une surface plane 63 inclinée faisant un angle θ inférieur à 90°, par exemple de 45°, avec l'axe longitudinal du canal capillaire 59, le reste de la face supérieure 55 faisant un angle pratiquement de 90° avec l'axe longitudinal du canal capillaire. Au niveau de la surface 63, le canal capillaire 59 débouche dans l'ouverture 61 par un tronçon incliné 65 de section plus faible mais dont les bords vont en s'élargissant car ils font avec la surface 63 un angle inférieur à 90°, par exemple de 45°.

Cette filière convient en particulier au préformage du saphir ($Al_2O_3$). Sa forme et celle de la base qui la supporte ont été spécialement étudiées pour optimiser le profil thermique sur la surface inclinée 63. Le ménisque qui se forme sur cette surface conserve ainsi d'excellentes conditions aux limites de contact avec cette surface tout au long de la croissance.

Cette filière est réalisée de préférence en molybdène.

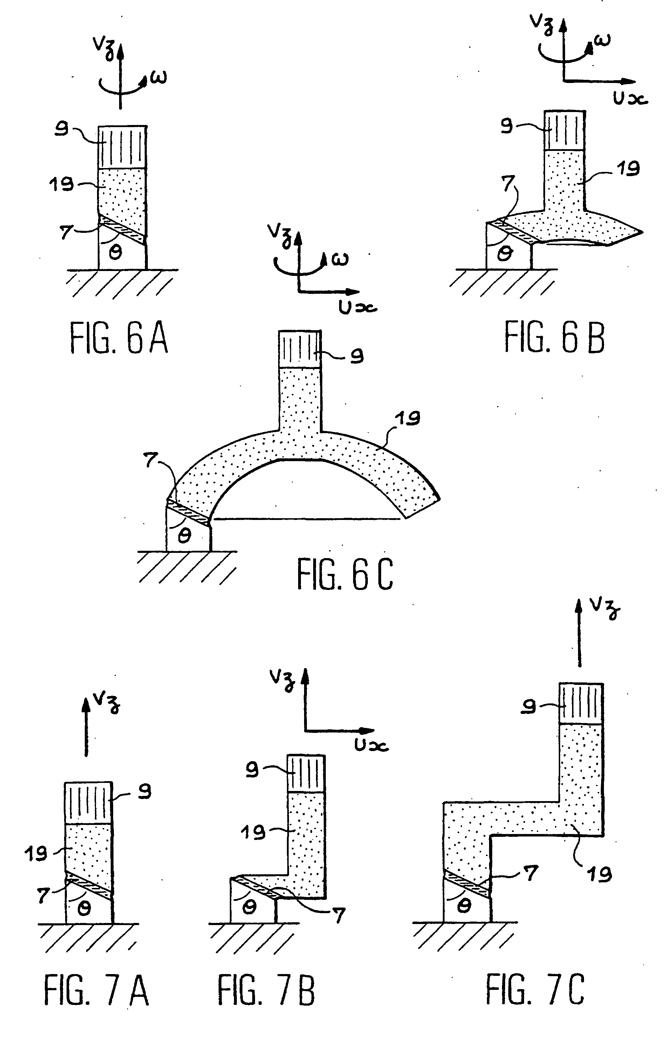

Sur les figures 6A à 6C, on a représenté la réalisation d'une calotte hémisphérique obtenue avec la filière de l'invention ayant un angle θ de 45°. Sur ces figures, on a utilisé les mêmes références que sur la figure 2.

Dans ce cas, on utilise le procédé de préformage local, qui consiste à faire varier en continu l'angle de tirage α, par la combinaison d'un mouvement de tirage vertical à la vitesse Vz, d'un mouvement de translation horizontale à la vitesse Ux et d'un mouvement de rotation du germe 9 à la vitesse ω.

Au début, figure 6A, on réalise un tronçon vertical par tirage vertical et rotation simultanée du germe 9.

On forme ensuite la partie hémisphérique en faisant varier les paramètres de croissance (Vz, Ux et ω) pour générer la sphère. Sur la figure 6B, le tirage s'effectue pratiquement horizontalement, puis l'angle de tirage change et diminue (figure 6C) au fur et à mesure que l'on forme la calotte hémisphérique.

Sur les figures 7A à 7C où l'on a repris les mêmes références, on a représenté la réalisation d'une pièce coudée par préformage classique, sans rotation du germe, avec la filière de l'invention.

Au départ (figure 7A), on réalise un tronçon vertical par tirage simple avec un seul mouvement du germe dans le sens vertical à la vitesse Vz.

On forme ensuite la partie coudée (figure 7B) en soumettant simultanément le germe à un mouvement horizontal et vertical aux vitesses Ux et Vz.

Après réalisation de la partie coudée, on poursuit la croissance (figure 7C) en utilisant uniquement le mouvement vertical Vz comme sur la figure 7A.

On peut bien entendu combiner les procédés décrits en relation avec les figures 6A, 6B, 6C, 7A, 7B, 7C pour former une calotte hémisphérique et la terminer par un barreau coudé, en arrêtant le mouvement de rotation du germe.

L'invention présente donc de nombreux avantages car elle permet la réalisation de formes complexes avec des matériaux difficiles à usiner comme par exemple le saphir qui possède des propriétés optiques, thermiques, mécaniques et chimiques très intéressantes.

Les domaines d'applications de ce matériau s'étendent de la bijouterie (verres de montre), à la production de pièces technologiques ultra-résistantes (buses et fenêtres à haute pression, outils de découpe), et aux dispositifs militaires de transmission infrarouge (IRdômes). Compte tenu de l'exceptionnelle dureté du saphir, le préformage en réduit sensiblement les coûts de production.

Le dispositif de croissance par inclinaison de l'interface de solidification étend le préformage à la réalisation de pièces jusque là impossibles à réaliser avec les filières classiques. La calotte hémisphériques, les gainages de formes particulières (par exemple des tubes creux et coudés), et les creusets spéciaux sont autant d'applications développables par ce procédé.

D'autres matériaux, même beaucoup plus facilement usinables que le saphir, sont aussi concernés par ce procédé, car certaines formes obtenues par préformage sont totalement irréalisables par usinage (typiquement les pièces creuses et coudées).

Références citées

1.La Belle Jr., J. of Crystal Growth, 50, 1980, p. 8-17,
2.Tatarchenko, Shaped Crystal Growth, Kluwer Academic Publishers, 1993, p. 1-18,
3.EP-A-653 504
4.US-A-4 430 305

**Revendications**

1. Filière pour le tirage de monocristaux ou de polycristaux à partir d'un bain fondu, comportant un corps (51) percé d'au moins un canal capillaire longitudinal (59) disposé entre une face inférieure (53) du corps destinée à être immergée dans le bain fondu et une face supérieure (55) du corps destinée à supporter le liquide provenant du bain fondu par le (les) canaux capillaires, dans laquelle ladite face supérieure (55) comprend au moins une surface plane (63) sur laquelle débouche le (les) canaux capillaire(s) (59), ladite surface plane formant un angle θ inférieur à 90° avec l'axe longitudinal du (des) canaux capillaires.

2. Filière selon la revendication 1, comportant un seul canal capillaire de section circulaire, carrée ou rectangulaire.

3. Filière selon la revendication 1, comportant un seul canal capillaire dont la section transversale est une couronne circulaire.

4. Filière selon la revendication 1, comportant plusieurs canaux capillaires débouchant en dessous de la face supérieure dans un seul canal capillaire de section rectangulaire.

5. Filière selon l'une quelconque des revendications 1 à 4, **caractérisée en ce que** l'angle θ est égal à 45°.

6. Filière selon l'une quelconque des revendications 1 à 5, dans laquelle les bords de l'ouverture (61) du canal capillaire sur la surface plane (63) de la face supérieure (55) de la filière forment un angle inférieur à 90° avec cette surface plane.

7. Filière selon l'une quelconque des revendications 1 à 5, comprenant un seul canal capillaire (59) et une face supérieure (55) dont une partie seulement forme la surface plane (63) faisant un angle θ inférieur à 90° avec l'axe longitudinal du canal capillaire, le canal capillaire (59) débouchant sur cette surface plane par un tronçon (65) incliné par rapport à l'axe longitudinal du canal.

8. Fillière selon la revendication 7 dans laquelle le tronçon (65) a une section transversale plus faible que celle du reste du canal capillaire.

9. Filière selon la revendication 8 dans laquelle les bords de l'ouverture (61) par laquelle le tronçon (65) débouche sur la surface plane (63) de la face supérieure de la filière forment un angle inférieur à 90° avec cette surface plane.

10. Filière selon l'une quelconque des revendications 1 à 9, dans laquelle les bords de l'ouverture (61) du canal capillaire (59) font avec la surface plane (63) de la face supérieure de la filière un angle de 45°.

11. Filière selon l'une quelconque des revendications 1 à 10, réalisée en molybdène.

12. Procédé de fabrication d'une pièce en matériau polycristallin ou monocristallin, consistant à former la pièce à partir d'un bain du matériau fondu par tirage au travers d'une filière (3) selon l'une quelconque des revendications 1 à 11, percée d'au moins un canal capillaire (5, et cristallisation du matériau fondu sortant du canal capillaire au contact d'un germe (9), le germe et/ou la filière étant soumis à au moins une mouvement de translation et/ou de rotation dans un plan perpendiculaire à la direction de tirage, dans lequel l'interface de cristallisation (11) du matériau fondu forme un angle θ inférieur à 90° avec la direction de tirage.

**Patentansprüche**

1. Düse für das Ziehen von Monokristallen oder Polykristallen aus einem Schmelzbad, einen Körper (51) umfassend, durchbohrt von wenigstens einem longitudinalen kapillaren Kanal (59), der verläuft zwischen einer Unterseite (53) des Körpers, die dazu bestimmt ist, in das Schmelzbad eingetaucht zu werden, und einer Oberseite (55) des Körpers, die dazu bestimmt ist, die Flüssigkeit zu tragen bzw. zu stützen, die durch den (die) kapillaren Kanal (Kanäle) aus dem Schmelzbad kommt, wobei die genannte Oberseite (55) wenigstens eine ebene Fläche (63) umfasst, in welcher der (die) kapillare(n) Kanal (Kanäle) (59) mündet (münden) und diese ebene Fläche (63) mit der Längsachse des (der) kapillaren Kanals (Kanäle) einen Winkel θ von weniger als 90° bildet.

2. Düse nach Anspruch 1 mit einem einzigen kapillaren Kanal von kreisrundem, quadratischem oder recheckigem Querschnitt.

3. Düse nach Anspruch 1 mit einem einzigen kapillaren Kanal, dessen Querschnitt ein kreisrunder Ring ist.

4. Düse nach Anspruch 1 mit mehreren kapillaren Kanälen, die unter der Oberseite in einem einzigen kapillaren Kanal mit rechteckigem Querschnitt münden.

5. Düse nach einem der Ansprüche 1 bis 4, **dadurch gekennzeichnet, dass** der Winkel θ gleich 45° ist.

6. Düse nach einem der Ansprüche 1 bis 5, bei der die Ränder der Öffnung (61) des kapillaren Kanals an der ebenen Fläche (63) der Oberseite (55) der Düse mit dieser ebenen Fläche einen Winkel von weniger als 90° bilden.

7. Düse nach einem der Ansprüche 1 bis 5 mit einem einzigen kapillaren Kanal (59) und einer Oberseite (55), von der nur ein Teil die ebene Fläche (63) bildet, die mit der Längsachse des kapillaren Kanals einen Winkel θ von weniger als 90° bildet, wobei der kapillare Kanal (59) in dieser ebenen Fläche durch ein Teilstück (65) mündet, das schräg ist in Bezug auf die Längsachse des Kanals.

8. Düse nach Anspruch 7, bei der das Teilstück (65) einen kleineren Querschnitt hat als der Rest des kapillaren Kanals.

9. Düse nach Anspruch 8, bei der die Ränder der Öffnung (61), durch die das Teilstück (65) in der ebenen Fläche (63) der Oberseite der Düse mündet, mit dieser ebenen Fläche einen Winkel θ von weniger als 90° bilden.

10. Düse nach einem der Ansprüche 1 bis 9, bei der die Ränder der Öffnung (61) des kapillaren Kanals (59) mit der ebenen Fläche (63) der Oberseite der Düse einen Winkel von 45° bilden.

11. Düse nach einem der Ansprüche 1 bis 10, hergestellt aus Molybdän.

12. Verfahren zur Herstellung eines Teils aus polykristallinem oder monokristallinem Material, darin bestehend, dieses Teil, ausgehend von einem Bad aus geschmolzenem Material, auszubilden durch Ziehung durch eine Düse (3) nach einem der Ansprüche 1 bis 11, die von wenigstens einem kapillaren Kanal (5) durchbohrt wird, und Kristallisation des aus dem kapillaren Kanal kommenden geschmolzenen Materials, in Kontakt mit einem Keim (9), wobei der Keim und/oder die Düse wenigstens einer Translations- und/oder Rotationsbewegung in einer zu der Ziehrichtung senkrechten Ebene ausgesetzt sind, in der die Kristallisationsgrenzschicht (11) des geschmolzenen Materials mit der Ziehrichtung einen Winkel θ von weniger als 90° bildet.

## Claims

1. Die for drawing mono-crystals or poly-crystals from a molten bath, comprising a body (51) bored with at least one longitudinal capillary channel (59) arranged between a lower face (53) of the body intended to be immersed in the molten bath and an upper face (55) of the body intended to support the liquid coming from the molten bath through the capillary channel or channels, wherein said upper face (55) comprises at least one flat surface (63) onto which the capillary channel or channels (59) emerge, said flat surface forming an angle θ, less than 90° with the longitudinal axis of the capillary channel or channels.

2. Die according to claim 1, comprising a single capillary channel of circular, square or rectangular section.

tion.

3. Die according to claim 1, comprising a single capillary channel, the cross section of which is a circular crown.

4. Die according to claim 1, comprising several capillary channels that emerge below the upper face into a single capillary channel of rectangular section.

5. Die according to any one of claims 1 to 4, **characterized in that** the angle θ is equal to 45°.

6. Die according to any one of claims 1 to 5, wherein the edges of the opening (61) of the capillary channel on the flat surface (63) of the upper face (55) of the die form an angle less than 90° with this flat surface.

7. Die according to any one of claims 1 to 5, comprising a single capillary channel (59) and an upper face (55), only one part of which forms the flat surface (63) making an angle θ less than 90° with the longitudinal axis of the capillary channel, the capillary channel (59) emerging onto this flat surface through a section (65) inclined with respect to the longitudinal axis of the channel.

8. Die according to claim 7, wherein the section (65) has a cross section smaller than that of the rest of the capillary channel.

9. Die according to claim 8, wherein the edges of the opening (61) through which the section (65) emerges onto the flat surface (63) of the upper face of the die form an angle less than 90° with this flat surface.

10. Die according to any one of claims 1 to 9, wherein the edges of the opening (61) of the capillary channel (59) make an angle of 45° with the flat surface (63) of the upper face of the die.

11. Die according to any one of claims 1 to 10, produced in molybdenum.

12. Method of manufacturing an item made of a polycrystalline or monocrystalline material, consisting of forming the item from a bath of molten material by drawing it through a die (3) bored with at least one capillary channel (5) and crystallizing the molten material coming out of the capillary channel in contact with a seed (9), the seed and/or the die being subjected to at least one translational movement and/or rotational movement in a plane perpendicular to the direction of drawing, wherein the crystallization interface (11) of the molten material forms an angle θ less than 90° with the direction of drawing.

$V_z$

9

11

10

3

7

2

1

5

FIG. 1

$V_z$

9

19

$a$

$d$

11

$b$

7

$Hm$

FIG. 2

3

5

$Ux$

FIG. 3

FIG. 4

FIG. 5

FIG. 6 A

FIG. 6 B

FIG. 6 C

FIG. 7 A

FIG. 7 B

FIG. 7 C